# EUROPÄISCHE PATENTANMELDUNG

(11) **EP 3 112 839 A1**
(43) Veröffentlichungstag der Anmeldung: **04.01.2017**
(21) Anmeldenummer: 16177059.9
(22) Anmeldetag: 30.06.2016
(51) Int. Cl.: G01M 15/12

(54) **TRAGBARE MESSSONDE**

(30) Priorität: 03.07.2015 AT 505792015
(71) Anmelder: AVL DiTest GmbH, 8020 Graz (AT)
(72) Erfinder: Bloder, Hannes, 8075 Hart bei Graz (AT); Lucchini, Jean-Marc, 8081 Empersdorf (AT); Lukesch, Walter, 8041 Graz (AT)
(74) Vertreter: Patentanwälte Pinter & Weiss OG

(57) **Zusammenfassung**

Um mit einer Messsonde auf einfache Weise verschiedene Messungen an einem Fahrzeug oder einem Verbrennungsmotor durchführen zu können, ist vorgesehen, dass die tragbare Messsonde mit einem geschlossenem Gehäuse (2) ausgeführt ist, in dem zumindest zwei Messsensoren (4, 5, 6) zur kontaktlosen Messung von zwei verschiedenen Messgrößen angeordnet sind und die zumindest zwei Messsensoren (4, 5, 6) zwei elektrische Messsignale (M1, M2, M3) erzeugen, die jeweils an einer Ausgangsschnittstelle (11) ausgebbar sind

## Beschreibung

Die gegenständliche Erfindung betrifft eine tragbare Messsonde und eine Anordnung zur Analyse eines Teils eines Fahrzeugs mit einer solchen tragbaren Messsonde.

In der Diagnostik von Verbrennungsmotoren und Fahrzeugen in Werkstätten kommen verschiedene Messgeräte zum Einsatz. Oftmals werden dabei auch Messsignale mittels geeigneter Sensoren aufgenommen und auf einem Oszilloskop dargestellt, in der Regel bezogen auf zumindest ein anderes Messsignal. Ein Messsignal kann auch ein Signal sein, das von einem Steuergerät des Fahrzeugs, wie beispielsweise dem Motorsteuergerät, ausgegeben oder initiiert wird.

Bekannt ist es in diesem Zusammenhang akustische, optische oder elektrische Größen mit-tels Messsensoren zu erfassen, gegebenenfalls in elektrische Größen umzuwandeln und auf einem Oszilloskop anzuzeigen.

Die EP 97 211 A1 beschreibt ein Gerät um die Brennstoffeinspritzung zu untersuchen, indem ein Geräusch einer bestimmten Frequenz aufgenommen und ausgewertet wird. Die Aufnahme des Geräusches kann dabei auch durch ein Richtmikrofon erfolgen, das in die Näher der Geräuschquelle, beispielsweise der Einspritzdüse, gehalten wird. Das vom Mikrofon erzeugte Messsignal kann auch auf einem Oszilloskop angezeigt werden. Das pulsförmige Signal des Richtmikrofons wird auch verwendet, um eine Stroboskoplampe anzusteuern. Auf einem rotierenden Teil, wie der Kurbelwelle, des Verbrennungsmotors ist eine Markierung angebracht und die Steuerimpulse für die Stroboskoplampe werden so justiert, dass die Stroboskoplampe immer dann aufleuchtet, wenn die Markierung eine Referenzposition passiert. Die Pulse des Mikrofons entsprechen dann den Einspritzzeitpunkten und die Pulse der Stroboskoplampe einer Referenzposition der Kurbelwelle, womit der korrekte Einspritzzeitpunkt überprüft werden kann.

Im Werkstättenumfeld ist auch bekannt, dass ein aufgenommenes akustisches Signal direkt über einen Kopfhörer von einem Anwender ausgewertet wird.

Die GB 2 283 576 A beschreibt einen Motoranalysator mit einer Hall-Sensor Sonde, um ein Stromsignal, beispielsweise den Strom durch eine Zündspule oder der Strom einer Einspritzdüse, aufzunehmen und um das erhaltene Messsignal auf einem Oszilloskop darzustellen. Die Hall-Sensor Sonde ist dabei als Stromzange ausgeführt. Eine Strommesszange ist zumeist mit zwei Hall Sensoren ausgeführt, die aufwändig abgestimmt und kalibriert werden müssen, um eine genaue Strommessung zu ermöglichen. Stromzangen sind folglich in der Regel teuer und umständlich in der Handhabung. Insbesondere ist man durch deren Größe in der Anwendung im engen Motorraum stark limitiert.

Werkstättenpersonal ist in der Regel nicht ausgebildet, um verschiedenste Messgeräte richtig bedienen zu können, insbesondere, um die Messsensoren richtig anordnen zu können und um die verschiedenen Messsignale richtig auswerten zu können. Damit ist es besonders im Werkstättenumfeld wichtig, Geräte zur Analyse eines Fahrzeugs oder eines Verbrennungsmotors eines Fahrzeugs so einfach wie möglich zu machen, um einer Fehlbedienung vorbeugen zu können. Dabei ist auch wichtig, dass eine Untersuchung nicht nur einfach, sondern auch rasch durchgeführt werden soll.

Es ist daher eine Aufgabe der gegenständlichen Erfindung, eine Messsonde anzugeben, mit der auf einfache Weise verschiedene Messungen an einem Fahrzeug oder eine Verbrennungsmotor durchgeführt werden können.

Diese Aufgabe wird erfindungsgemäß dadurch gelöst, indem die tragbare Messsonde mit einem geschlossenem Gehäuse ausgeführt ist, in dem zumindest zwei Messsensoren zur kontaktlosen Messung von zwei verschiedenen Messgrößen angeordnet sind und die zumindest zwei Messsensoren zwei elektrische Messsignale erzeugen, die jeweils an einer Ausgangsschnittstelle ausgebbar sind. Eine solche Messsonde ist einfach handzuhaben und kann für verschiedene Messungen eingesetzt werden

Besonders vorteilhaft ist ein im Gehäuse angeordneter akustischer Messsensor. Wird dieser mit einer am Gehäuse angeordneten Messfühler kombiniert, wobei ein Ende der Messfühler im Gehäuse in einem vorgegebenen Abstand vom akustischen Messsensor endet, kann sehr einfach ein zu untersuchender Bauteil akustisch untersucht werden. Über die Messfühler können auch schwer zugängliche Stellen gut erreicht werden.

In einer anderen vorzugsweisen Ausgestaltung ist im Gehäuse ein Hall-Sensor angeordnet. Mit jenem einzigen Hall-Sensor kann einfach festgestellt werden, ob ein elektrischer Strom durch einen Leiter fließt oder nicht.

Ebenso ist es vorteilhaft, wenn im Gehäuse hinter einer Optik ein Lichtsensor angeordnet ist. Damit können auch zeitaufgelöste Messungen einer Lichtintensität durchgeführt werden.

Mit einem Leuchtmittel im Gehäuse hinter einer Optik kann auf einfache Weise eine Taschenlampenfunktion oder eine Stroboskopfunktion realisiert werden. Mit dem Lichtsensor kann sogar das reflektierte Licht des Leuchtmittels ausgewertet werden.

Eine einfache Sicherheitsfunktion kann implementiert werden, wenn die Messsonde das Leuchtmittel aktiviert, wenn der Hall-Sensor ein Messsignal erfasst.

Um die aufgenommenen Messsignale besser auswerten zu können, kann in der Messsonde eine Auswerteeinheit vorgesehen sein, die die Messsignale verarbeitet und die verarbeiteten Messsignale an der Ausgangsschnittstelle ausgibt.

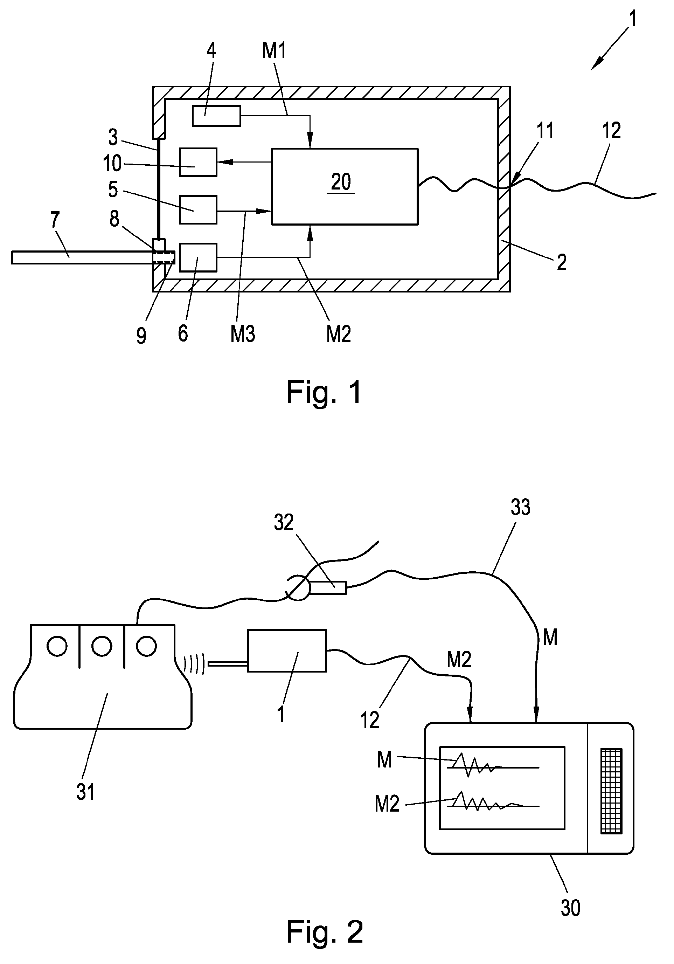

Die gegenständliche Erfindung wird nachfolgend unter Bezugnahme auf die Figuren 1 und 2 näher erläutert, die beispielhaft, schematisch und nicht einschränkend vorteilhafte Ausgestaltungen der Erfindung zeigen. Dabei zeigt
Fig.1 eine Darstellung der erfindungsgemäßen Messsonde und
Fig.2 eine Anordnung zur Analyse eines Teils eines Fahrzeugs mit der tragbaren Messsonde.

Die Messsonde 1 ist als tragbares Gerät ausgeführt und kann damit von Hand gehalten und geführt werden, was eine einfache Handhabung ermöglicht. Die Messsonde 1 umfasst ein geschlossenes Gehäuse 2, an dem eine Optik 3 vorgesehen sein kann. Die Optik 3 kann ein einfaches Glas sein, kann aber auch eine optische Funktion realisieren, beispielsweise in Form einer Linse, eines optischen Filters, etc. Im Gehäuse 2 sind verschiedene Messsensoren 4, 5, 6 angeordnet, wobei in der Messsonde 1 zumindest zwei Messsensoren vorgesehen sind.

Ein Messsensor 4 kann ein Hall-Sensor zur Erfassung von relativen elektrischen Strömen sein. Für die erfindungsgemäße Anwendung kommt es nicht auf die genaue Messung von elektrischen Strömen an, sondern nur auf die Detektion des Vorhandenseins elektrischer Ströme. Der Hall-Sensor benötigt daher lediglich eine ausreichende Sensibilität, aber keine hohe Genauigkeit in der Auflösung der Messgröße (elektrischer Strom). Der Hall-Sensor kann daher zur zeitaufgelösten Messung der Ansteuerung von Aktuatoren (z.B. Drosselklappenverstellung), Injektoren (z.B. Einspritzdüsen), Spulen (z.B. Zündspule) oder Ventilen (z.B. ein Gasventil) verwendet werden. Dazu muss die Messsonde 1 lediglich in die Nähe einer stromführenden Leitung gehalten werden, sodass der Hall-Sensor einen fließenden Strom detektieren kann. Der Hall-Sensor liefert ein elektrisches Messsignal M1.

Ein Messsensor 6 kann ein akustischer Sensor zur Erfassung von Schallwellensein. Dazu ist am Gehäuse 2 vorteilhafterweise ein Messfühler 7 zur Aufnahme der Schallwellen angeordnet. Am Gehäuse 2 kann dazu ein Gewindeloch 8 vorgesehen sein, in die ein Ende des Messfühlers 7 eingeschraubt wird. Der Messfühler 7 kann daher bei Bedarf aufgeschraubt werden. Der Messfühler 7 ist hierzu vorzugsweise als stabförmiger Messfühler ausgeführt. Ein Ende 9 des Messfühlers 7 endet im Gehäuse 2 in einem vorgegebenen Abstand, typischer Weise im Bereich von einigen Millimetern, zum akustischen Sensor. Der Messfühler 7 kann damit mit dem vom Gehäuse 2 wegstehenden Ende in die Nähe einer Geräuschquelle gehalten werden, beispielsweise ein Einspritzventil. Der Messfühler 7 nimmt die mechanische Energie der Schallwelle oder einer mechanischen Schwingung auf und leitet diese an das andere Ende 9 des Messfühlers 7 weiter. Es ist auch der zeitliche Verlauf der Schallwelle erfassbar. Am Ende 9 wird das akustische Signal wieder abgestrahlt und wird vom akustischen Sensor erfasst und in ein elektrisches Messsignal M2 umgewandelt. Mit dem Messsensor 6 können auch mechanische Schwingungen von Bauteilen, die ebenfalls Schallwellen verursachen können, erfasst werden.

Der Messfühler 7 muss für eine akustische Messung nicht in Kontakt mit einem Messpunkt am Fahrzeug oder am Verbrennungsmotor sein. Es ist aber vorteilhaft, den Messfühler am Messpunkt anzulegen. Umgebungsgeräusche wirken sich wegen ihrer relativen Schwäche nicht, oder nur sehr gering auf das Messsignal M2 aus. Eventuelle Störgeräusche können über geeignete Filter auch herausgefiltert werden.

Ein Messsensor 5 kann ein Lichtsensor sein, mit dem die Lichtintensität erfasst werden kann. Der Lichtsensor ist im Gehäuse 2 hinter der Optik 3 angeordnet. Der Lichtsensor erfasst von einer externen Lichtquelle abgegebenen Licht und wandelt die Lichtintensität in ein elektrisches Messsignal M3 um. Mit dem Lichtsensor kann beispielsweise die Lichtintensität einer Kontrollleuchte des Fahrzeugs gemessen werden. Es ist auch der zeitliche Verlauf der Lichtintensität einer externen Lichtquelle erfassbar.

Im Gehäuse 2 kann auch eine Lichtquelle 10, beispielsweise ein LED angeordnet sein, vorzugsweise hinter eine Optik 3. Mit der Lichtquelle 10 kann Licht von der Messsonde 1 abgegeben werden. Auf diese Weise kann eine Taschenlampenfunktion oder auch eine Stroboskopfunktion realisiert werden. Es ist aber auch denkbar, dass das von der internen Lichtquelle 10 abgestrahlte Licht an einer Fläche reflektiert wird und das reflektierte Licht mit dem Lichtsensor erfasst wird. Damit kann auch Stroboskoplicht als zeitaufgelöstes Messsignal M3 erfasst werden.

Die interne Lichtquelle 10 kann auch zur Signalisierung verwendet werden. Beispielsweise ist es denkbar, die Lichtquelle 10 zu aktivieren, wenn mit dem Messsensor 4 (Hall-Sensor) ein Strom detektiert wird. Damit kann eine Bedienperson direkt an der Messsonde 1 erkennen, ob eine elektrische Leitung einen elektrischen Strom führt.

In der Messsonde 1 kann eine beliebige Kombination der Messsensoren 4, 5, 6 verwendet werden, wobei es besonders vorteilhaft ist, wenn in der Messsonde 1 alle Messsensoren 4, 5, 6 verbaut sind. In einer bevorzugten Ausgestaltung der Messsonde 1 ist zumindest der Messsensor 6 in Form eines akustischen Sensors und der Messfühler 7 verbaut. Der Messsensor 6 kann dann mit beliebigen anderen Messsensoren 4, 5 kombiniert werden.

Mit jedem der Messsensoren 4, 5, 6 kann eine kontaktlose Messung (im Sinne, dass keine direkte Berührung zwischen Messsensor 4, 5, 6 und einem Bauteil notwendig ist) einer Messgröße erfolgen, was die Handhabung der Messsonde 1, insbesondere in engen Umgebungen wie einem Motorraum eines Fahrzeugs, erheblich erleichtert.

In der Messsonde 1 ist weiters eine Auswerteeinheit 20 vorgesehen, der die Messsignale M1, M2, M3 zugeführt werden. In der Auswerteeinheit 20 können die Messignale M1, M2, M3 bedarfsgerecht aufbereitet, z.B. gefiltert, verstärkt, etc., und für die Ausgabe vorbereitet, z.B. durch eine Pegelanpassung, etc., werden.

An der Messsonde 1 ist weiters eine Ausgangsschnittstelle 11 vorgesehen. Über die Ausgangsschnittstelle 11 kann eines der Messsignale M1, M2, M3, entweder direkt oder über die Auswerteeinheit 20, ausgegeben werden. Damit kann die Messsonde 1 über ein mit der Ausgangsschnittstelle 11 verbundenes Anschlusskabel 12 mit einem externen Oszilloskop 30 verbunden werden. Ein Messsignal M1, M2, M3 kann hier analog oder digital ausgegeben werden. Ebenfalls ist es denkbar, für verschiedene Messsignale M1, M2, M3 jeweils ein eigenes Kabel vorzusehen, um die Messsonde 1 an ein mehrkanaliges Oszilloskop 30 anzuschließen. Werden Messsignale M1, M2, M3 digital ausgegeben, dann kann auch ein Kabel ausreichen, um mehrere Messsignale M1, M2, M3 digital zu übertragen.

In einer bevorzugten Ausgestaltung erkennt die Auswerteeinheit 20, z.B. über die Signalpegel, mit welchem Messsensor 4, 5, 6 gerade gemessen wird. Alternativ kann dazu an der Messsonde 1 auch eine entsprechende Einstellung vorgenommen werden, um einen Messmodus einzustellen. Die Auswerteeinheit 20 gibt dann das zugehörige Messsignale M1, M2, M3 an der Ausgangsschnittstelle 11 aus.

Mit Fig.2 ist eine Anordnung zur Analyse eines Teils eines Fahrzeugs, hier ein Verbrennungsmotor, mit einer tragbaren Messsonde 1 dargestellt. Die Messsonde 1 wird mit dem Messfühler 7 an eine interessierende Stelle gehalten, beispielsweise an ein Einspritzventil, um Geräusche bzw. mechanische Schwingungen des Einspritzventils aufzunehmen. Mit einer Stromzange 32 wird gleichzeitig der Strom in einer elektrischen Zuführung zum Einspritzventil gemessen, um den elektrischen Strom, mit das Einspritzventil angesteuert wird, zu erfassen. Die Stromzange 32 liefert ein Messsignal M. Das Messsignal M2 der Messsonde 1 wird über das Anschlusskabel 12 an ein Oszilloskop 30 übertragen. Das Messsignal M der Stromzange 32 wird über ein Stromzangenkabel 33 an das Oszilloskop 30 übermittelt. Am Oszilloskop 30 werden die Messsignale M, M2 zeitaufgelöst und bezogen aufeinander dargestellt werden. Die beiden Messsignale M, M2 können dabei gleichzeitig dargestellt werden, womit die Messsignale auch zeitlich in Bezug zueinander gesetzt werden können, um die Auswertung zu erleichtern.

So können verschiedene Messgrößen erfasst und am Oszilloskop 30 dargestellt werden. Am Oszilloskop 30 können gleichzeitig mehrere Messsignale M, M1, M2, M3, auch aus anderen Quellen, beispielsweise ein Signal aus einem Steuergerät des Fahrzeugs, dargestellt werden. Über die Auswerteeinheit 20 der Messsonde 1 kann auch ein Ansteuersignal des Leuchtmittels 10 ausgegeben werden, wenn dieses als Stroboskoplicht verwendet wird. Damit kann das Oszilloskop 30 auch auf diese Ansteuersignale synchronisiert werden.

Das Oszilloskop 30 kann ein analoges oder digitales Oszilloskop sein. Das digitale Oszilloskop könnte auch als Software auf einer Recheneinheit mit einem grafischen Display implementiert sein.

## Patentansprüche

1. Tragbare Messsonde mit einem geschlossenem Gehäuse (2), in dem zumindest zwei Messsensoren (4, 5, 6) zur kontaktlosen Messung von zwei verschiedenen Messgrößen angeordnet sind und die zumindest zwei Messsensoren (4, 5, 6) zwei elektrische Messsignale (M1, M2, M3) erzeugen, die jeweils an einer Ausgangsschnittstelle (11) ausgebbar sind.

2. Tragbare Messsonde nach Anspruch 1, **dadurch gekennzeichnet, dass** im Gehäuse (2) ein akustischer Messsensor (6) angeordnet ist.

3. Tragbare Messsonde nach Anspruch 2, **dadurch gekennzeichnet, dass** am Gehäuse (2) ein Messfühler (7)angeordnet ist, wobei ein Ende des Messfühlers (7) im Gehäuse (2) in einem vorgegebenen Abstand vom akustischen Messsensor (6) endet.

4. Tragbare Messsonde nach Anspruch 3, **dadurch gekennzeichnet, dass** am Gehäuse (2) ein Gewindeloch (8) vorgesehen ist, in die der Messfühler (7) mit einem Ende einschraubbar ist.

5. Tragbare Messsonde nach Anspruch 1, **dadurch gekennzeichnet, dass** im Gehäuse (2) ein Hall-Sensor (4) angeordnet ist.

6. Tragbare Messsonde nach Anspruch 1, **dadurch gekennzeichnet, dass** im Gehäuse (2) hinter einer Optik (3) ein Lichtsensor (3) angeordnet ist.

7. Tragbare Messsonde nach Anspruch 1, **dadurch gekennzeichnet, dass** im Gehäuse (2) hinter einer Optik (3) ein Leuchtmittel (10) angeordnet ist.

8. Tragbare Messsonde nach Anspruch 5 und 7, **dadurch gekennzeichnet, dass** die Messsonde (1) das Leuchtmittel (10) aktiviert, wenn der Hall-Sensor (4) ein Messsignal (M1) erfasst.

9. Tragbare Messsonde nach einem der Ansprüche 1 bis 8, **dadurch gekennzeichnet, dass** in der Messsonde (1) eine Auswerteeinheit (20) vorgesehen ist, die die Messsignale (M1, M2, M3) verarbeitet und die verarbeiteten Messsignale (M1, M2, M3) an der Ausgangsschnittstelle (11) ausgibt.

10. Anordnung zur Analyse eines Teils eines Fahrzeugs mit einer tragbaren Messsonde (1) nach einem der Ansprüche 1 bis 9 und einem Oszilloskop (30), das mit der Ausgangsschnittstelle (11) der Messsonde (1) verbunden ist, wobei am Oszilloskop (30) zumindest ein von der Messsonde (1) ausgegebenes Messsignal (M1, M2, M3) angezeigt wird.
